# DEMANDE DE BREVET EUROPEEN

(11) **EP 4 576 567 A1**
(43) Date de publication de la demande: **25.06.2025**
(21) Numéro de dépôt: 23315486.3
(22) Date de dépôt: 21.12.2023
(51) Int. Cl.: H02S 50/10, H10K 30/50, H10K 85/50, H10K 71/70

(54) **PROCÉDÉ D'ESTIMATION DE LA RÉSISTANCE AU VIEILLISSEMENT D'UN MODULE PHOTOVOLTAÏQUE À BASE DE PÉROVSKITE ET DISPOSITIF ASSOCIÉ**

(71) Demandeur: TotalEnergies OneTech, 92400 Courbevoie (FR); Institut Photovoltaïque d'Ile de France - IPVF, 91120 Palaiseau (FR); Electricité de France, 75008 Paris (FR); Centre National de la Recherche Scientifique, 75794 Paris Cedex 16 (FR); Ecole Polytechnique, 91128 Palaiseau Cedex (FR)
(72) Inventeur: Medjoubi, Karim, 91120 PALAISEAU (FR); Nicolas, Maria, 92400 COURBEVOIE (FR)
(74) Mandataire: Innovincia

(57) **Abrégé**

La présente invention concerne un procédé d'estimation de la résistance au vieillissement d'un module photovoltaïque (5) à base de Pérovskite dans lequel on éclaire (101, 201) le module photovoltaïque (5) avec une lumière dont le spectre d'émission comprend au moins une partie du spectre d'absorption du module photovoltaïque (5) utilisé et dont l'irradiance est inférieure à un premier seuil prédéterminé, notamment inférieure à une fraction de l'irradiance utilisée pour caractériser l'efficacité d'un module photovoltaïque (5) et dans lequel on détermine (1022, 2022) la valeur de la résistance parallèle du module photovoltaïque (5) éclairé, la résistance au vieillissement étant déduite de la valeur de résistance parallèle mesurée, plus la valeur de résistance parallèle est faible et plus le module photovoltaïque (5) est résistant au vieillissement.

## Description

La présente invention concerne un vieillissement d'un module photovoltaïque à base de Pérovskite.

Les modules photovoltaïques à base de Pérovskite permettent d'obtenir des rendements de conversion très importants ce qui les rend très intéressants.

Cependant, ces modules photovoltaïques à base de Pérovskite présentent une faible stabilité de sorte que la résistance au vieillissement de différents échantillons peut varier dans des proportions importantes. Il convient donc de déterminer pour chaque échantillon, non seulement l'efficacité de l'échantillon, car cette efficacité peut également varier largement d'un échantillon à l'autre mais aussi estimer le vieillissement de l'échantillon afin de pouvoir garantir des performances conformes dans le temps.

Pour cela, des tests standards de résistance au vieillissement sont réalisés en éclairant les modules photovoltaïques pendant un temps prédéterminé, par exemple 100h ou 1000h et sous une irradiance prédéterminée, par exemple 1000W/m². Cependant, du fait de la durée importante de ces tests, le coût nécessaire à leur réalisation est important.

Il convient donc de détecter un maximum d'échantillons non conformes en amont du test standard afin de limiter le nombre d'échantillons à tester.

A cet effet, la présente invention concerne un procédé d'estimation de la résistance au vieillissement d'un module photovoltaïque à base de Pérovskite dans lequel on éclaire le module photovoltaïque avec une lumière dont le spectre d'émission comprend au moins une partie du spectre d'absorption du module photovoltaïque utilisé et dont l'irradiance est inférieure à un premier seuil prédéterminé, notamment inférieure à une fraction de l'irradiance utilisée pour caractériser l'efficacité d'un module photovoltaïque et dans lequel on détermine la valeur de la résistance parallèle du module photovoltaïque éclairé, la résistance au vieillissement étant déduite de la valeur de résistance parallèle mesurée, plus la valeur de résistance parallèle est faible et plus le module est résistant au vieillissement.

Selon un autre aspect de la présente invention, le seuil prédéterminé est le plus petit possible, notamment inférieur à 100W/m², notamment inférieur à 10W/m², notamment entre 1W/m² et 3W/m².

Selon un autre aspect de la présente invention, la lumière est obtenue par une lampe à diode électroluminescente et au moins un filtre neutre.

Selon un autre aspect de la présente invention, la valeur de la résistance parallèle est déterminée à partir d'une caractéristique courant-tension du module photovoltaïque.

La présente invention concerne également un procédé de caractérisation d'un module photovoltaïque à base de Pérovskite comprenant un procédé d'estimation de la résistance au vieillissement tel que décrit précédemment et une étape de caractérisation de l'efficacité du module photovoltaïque dans laquelle on éclaire le module photovoltaïque avec une lumière dont le spectre comprend au moins une partie du spectre d'absorption du module photovoltaïque et dont l'irradiance est égale à un deuxième seuil prédéterminé, supérieure au premier seuil prédéterminé.

Selon un autre aspect de la présente invention, le deuxième seuil prédéterminé est égal à 1000W/m².

La présente invention concerne également un dispositif d'estimation de la résistance au vieillissement d'un module photovoltaïque à base de Pérovskite comprenant une lampe à diode électroluminescente dont le spectre d'émission correspond au moins en partie au spectre d'absorption du module photovoltaïque, au moins un filtre neutre, des moyens de détermination d'une résistance parallèle du module photovoltaïque et une unité de traitement configurée pour :
- appliquer, via la lampe à diode électroluminescente, un éclairage du module photovoltaïque dont l'irradiance est inférieure à un premier seuil prédéterminé, notamment inférieure à une fraction de l'irradiance utilisée pour caractériser l'efficacité d'un module photovoltaïque,
- déterminer, via les moyens de détermination de la résistance parallèle, une valeur de la résistance parallèle du module photovoltaïque éclairé et,
- déduire une résistance au vieillissement du module photovoltaïque en fonction de la valeur de résistance parallèle déterminée.

Selon un autre aspect de la présente invention, la résistance parallèle est déterminée à partir d'une caractéristique courant-tension et les moyens de détermination de la résistance parallèle comprennent des moyens d'application d'une tension variable au module photovoltaïque et des moyens de mesure du courant dans le module photovoltaïque.

Selon un autre aspect de la présente invention, le dispositif comprend une base de données comprenant un ensemble de caractéristiques courant-tension et/ou de valeurs de résistances parallèles et dans lequel l'unité de traitement est configurée pour comparer la caractéristique courant-tension et/ou la résistance parallèle déterminée avec les caractéristiques courant-tension et/ou les résistances parallèles de la base de données pour déduire une résistance au vieillissement du module photovoltaïque éclairé.

Selon un autre aspect de la présente invention, l'unité de traitement est également configurée pour :
- appliquer, via la lampe à diode électroluminescente, un éclairage du module photovoltaïque dont l'irradiance est égale à un deuxième seuil prédéterminé,
- déterminer, via les moyens de détermination de la résistance parallèle, la résistance parallèle du module photovoltaïque éclairé et,
- estimer une efficacité du module photovoltaïque éclairé en fonction notamment de la résistance parallèle déterminée.

Selon un autre aspect de la présente invention, le dispositif est configuré pour :
- recevoir et éclairer plusieurs modules photovoltaïques simultanément,
- mesurer les résistances parallèles des différents modules photovoltaïques et,
- déduire une résistance au vieillissement des différents modules photovoltaïques à partir des résistances parallèles mesurées.

D'autres caractéristiques et avantages de l'invention apparaîtront plus clairement à la lecture de la description suivante, donnée à titre d'exemple illustratif et non limitatif, et des dessins annexés parmi lesquels :
[Fig 1] représente un organigramme des étapes d'un procédé d'estimation de la résistance au vieillissement d'un module photovoltaïque ;
[Fig 2] représente un exemple de dispositif d'estimation de la résistance au vieillissement d'un module photovoltaïque à base de Pérovskite ;
[Fig 3] représente un exemple de caractéristique courant-tension et puissance-tension sous une première irradiance pour deux modules photovoltaïques distincts ;
[Fig 4] représente un organigramme des étapes d'un procédé de caractérisation d'un module photovoltaïque.
[Fig 5] représente un exemple de caractéristique courant-tension et puissance-tension sous une seconde irradiance pour deux modules photovoltaïques distincts ;
[Fig 6] représente un exemple d'évolution au cours du temps de la puissance mesurée pour deux modules photovoltaïques distincts ;

Dans ces figures, les, éléments identiques portent les mêmes références.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

La présente invention concerne un procédé d'estimation de la résistance au vieillissement d'un module photovoltaïque à base de Pérovskite.

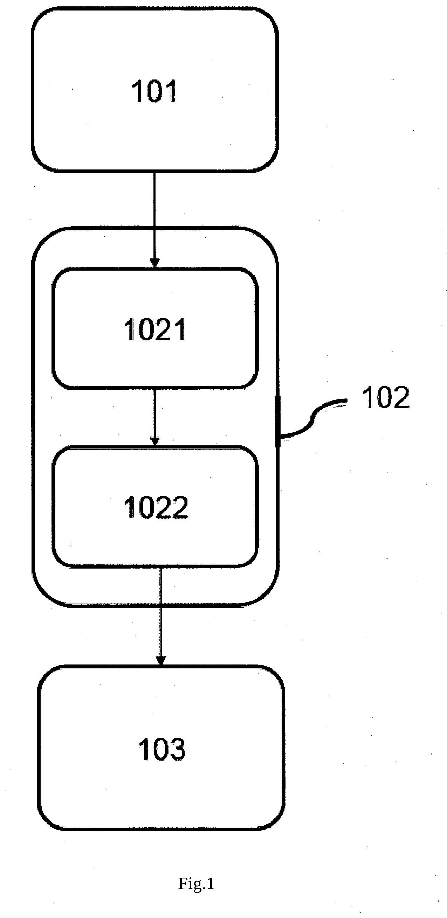

La figure 1 représente un organigramme des étapes du procédé.

La première étape 101 concerne une étape dans laquelle on éclaire le module photovoltaïque avec une irradiance inférieure à un premier seuil prédéterminé. Ce premier seuil prédéterminé est inférieur à un deuxième seuil prédéterminé associé à l'irradiance utilisée pour caractériser l'efficacité d'un module photovoltaïque. Le deuxième seuil prédéterminé est généralement égal à 1000W/m². Le premier seuil prédéterminé est par exemple inférieur à 100W/m², notamment inférieur à 10W/m², notamment entre 1 et 3W/m². En effet, dans cette première étape 101, on cherche à éclairer le module photovoltaïque avec une irradiance la plus faible possible. Une telle irradiance est par exemple obtenue en utilisant une lampe à diode électroluminescente, aussi appelée « light emitting diode (LED) » en anglais, associé à un filtre neutre, c'est-à-dire un filtre agissant de la même manière sur toutes les longueurs d'onde émises par la lampe à LEDs. La lampe peut comprendre une ou plusieurs LEDs. Il est également possible d'utiliser une lampe xénon ou une lampe halogène ou toute lampe permettant d'obtenir l'irradiance voulue et permettant d'émettre une lumière dont les longueurs d'onde sont comprises dans le spectre d'absorption du Pérovskite du module photovoltaïque éclairé.

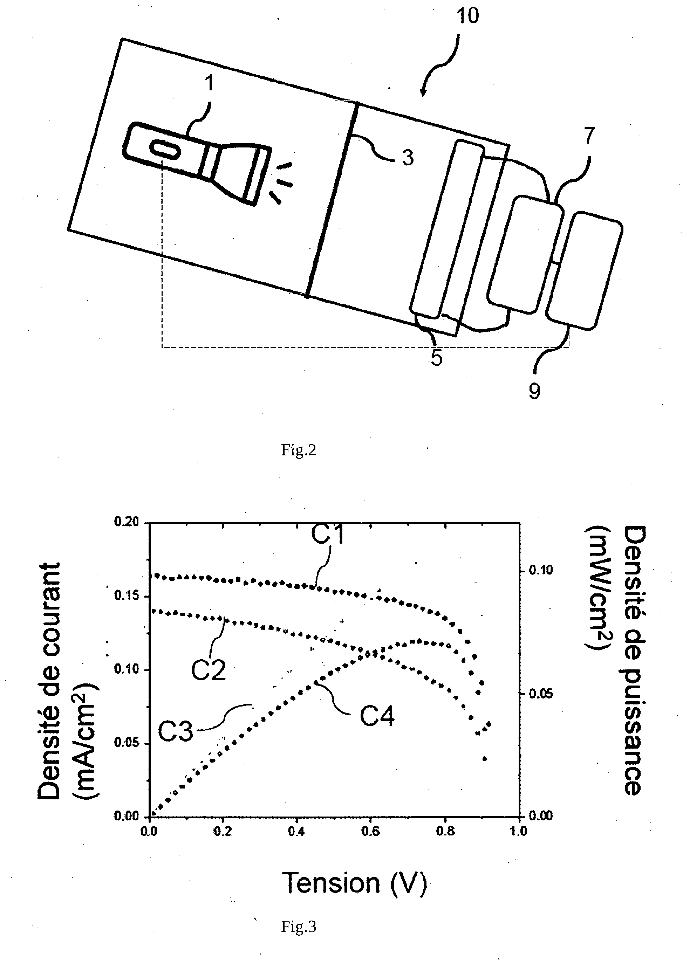

La figure 2 représente une vue schématique d'un dispositif 10 comprenant une lampe à LEDs 1 et un filtre neutre 3 pour éclairer un module photovoltaïque à base de Pérovskite 5. Par ailleurs la ou les LEDs sont choisie(s) de manière à émettre au moins en partie dans le spectre d'absorption du module photovoltaïque 5 utilisé, c'est-à-dire dans le spectre d'absorption du Pérovskite. Le spectre émis par la lampe à LEDs correspond par exemple à un spectre AM1.5G.

La deuxième étape 102 concerne la détermination d'une résistance parallèle, aussi appelée résistance « shunt » en anglais du module photovoltaïque 5 éclairé.

La deuxième étape 102 comprend par exemple une première sous-étape 1021 visant à déterminer une caractéristique courant-tension du module photovoltaïque 5. Pour cela, on applique une tension variable au module photovoltaïque 5, la tension varie par exemple entre 0V et la tension de circuit ouvert, aussi appelée « open circuit voltage (VOC) » en anglais, et on mesure l'intensité du courant circulant dans le module photovoltaïque 5 lorsque la tension varie. La figure 3 représente un exemple d'une caractéristique courant-tension obtenue sous un éclairage avec une irradiance comprise entre 1 et 3W/m² pour deux échantillons distincts. Les courbes C1 et C2 représentent les caractéristiques courant-tension et les courbes C3 et C4 représentent les caractéristiques puissance-tension respectivement pour le premier échantillon et pour le deuxième échantillon.

La deuxième sous-étape 1022 concerne la détermination de la résistance parallèle à partir de la caractéristique courant-tension obtenue lors de la première sous-étape 1021 en appliquant un modèle physique sur la courbe courant-tension ou courbe I-V. La résistance parallèle est par exemple obtenue en déterminant la pente des courbes C1 et C2 avant la cassure de pente (ici pour des valeurs de tension inférieures à 0,8V).

La troisième étape 103 concerne la détermination de la résistance au vieillissement du module photovoltaïque 5 éclairé. Cette résistance est déduite de la valeur de la résistance parallèle déterminée à l'étape 102. Plus la valeur de résistance parallèle est faible et plus le module est résistant au vieillissement. Dans le cas de la figure 3, le module photovoltaïque 5 associé à la courbe C.1 aura une résistance parallèle plus importante et donc une résistance au vieillissement plus faible que le module photovoltaïque 5 associé à la courbe C2. La valeur de résistance parallèle déterminée peut être comparée à des valeurs de résistances parallèles enregistrées dans une base de données. Des seuils peuvent être associés à des valeurs de résistance parallèle pour classer les différents modules photovoltaïques 5 dans différentes catégories de résistance au vieillissement en fonction de leur valeur de résistance parallèle.

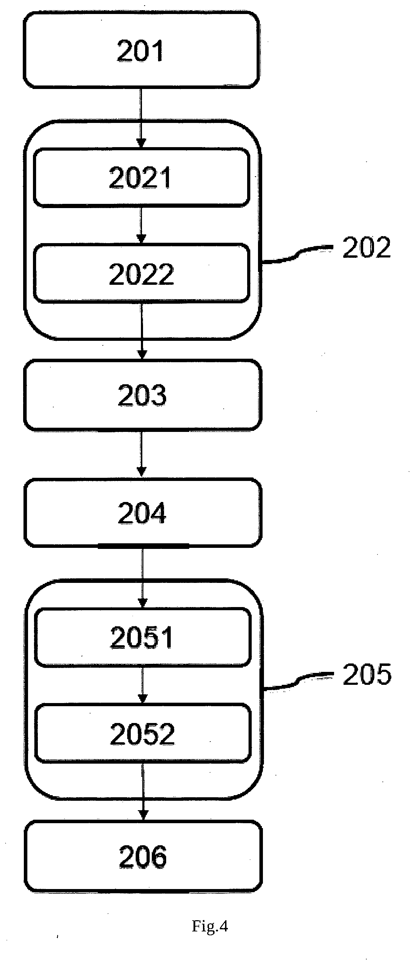

La présente invention concerne également un procédé de caractérisation d'un module photovoltaïque 5 à base de Pérovskite. La figure 4 représente l'organigramme des étapes d'un tel procédé. Les étapes 201 à 203 sont identiques aux étapes 101 à 103 du procédé d'estimation de la résistance au vieillissement décrit précédemment à partir de la figure 1. Le procédé de caractérisation comprend également des étapes 204 à 206 de caractérisation de l'efficacité du module photovoltaïque 5.

L'étape 204 concerne une étape dans laquelle on éclaire le module photovoltaïque 5 avec une lumière dont le spectre comprend au moins une partie du spectre d'absorption du module photovoltaïque 5, par exemple la lampe à LEDs 1 utilisée pour l'étape 101. L'irradiance de l'éclairage est égale à un deuxième seuil prédéterminé supérieur au premier seuil prédéterminé, par exemple 1000W/m².

La cinquième étape 205 concerne la détermination d'une résistance parallèle, aussi appelée résistance « shunt » en anglais du module photovoltaïque 5 éclairé.

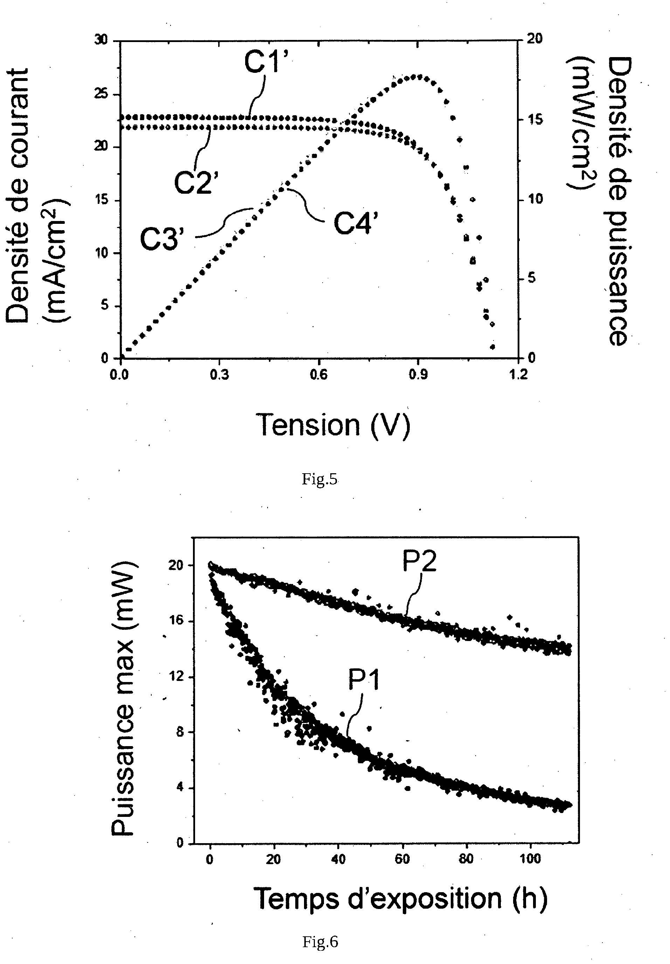

La cinquième étape 205 comprend par exemple une première sous-étape 2051 visant à déterminer une caractéristique courant-tension du module photovoltaïque 5. Pour cela, on applique une tension variable au module photovoltaïque 5. La tension appliquée varie par exemple entre 0V et la tension de circuit ouvert, aussi appelée « open circuit voltage (VOC) » en anglais, et on mesure l'intensité du courant circulant dans le module photovoltaïque pour les différentes valeurs de tension. La figure 5 représente un exemple d'une caractéristique courant-tension obtenue sous un éclairage avec une irradiance de 1000W/m² pour deux échantillons distincts. Les courbes C1' et C2' représentent les caractéristiques courant-tension et les courbes C3' et C4' représentent les caractéristiques puissance-tension.

La deuxième sous-étape 2052 concerne la détermination de la résistance parallèle à partir de la caractéristique courant-tension obtenue lors de la première sous-étape 2051 en appliquant un modèle physique sur la courbe courant-tension ou courbe I-V. La résistance parallèle est par exemple obtenue en déterminant la pente des courbes C1' et C2' avant la cassure de pentes (ici pour des valeurs de tension inférieures à 0,8V).

La sixième étape 206 concerne la détermination de l'efficacité du module photovoltaïque éclairé. Cette efficacité dépend de la valeur de la résistance parallèle déterminée à l'étape 205. Plus la valeur de résistance parallèle est élevée et plus le module a une efficacité élevée. Dans l'exemple de la figure 5, on peut remarquer que les modules photovoltaïques associés aux courbes C1 ' et C2' ont des valeurs de résistances parallèles très proches et ont donc une efficacité sensiblement égale. La valeur de résistance parallèle déterminée peut être comparée à des valeurs de résistances parallèles enregistrées dans une base de données. Des seuils peuvent être associés à des valeurs de résistance parallèle pour classer les différents modules photovoltaïques dans différentes catégories d'efficacité en fonction de leur valeur de résistance parallèle.

Alternativement, les étapes 204 à 206 peuvent être réalisées avant les étapes 201 à 203.

Ces procédés peuvent permettre d'exclure certains modules photovoltaïques ayant une efficacité ou une résistance au vieillissement trop faible.

La présente invention concerne également un dispositif 10 d'estimation de la résistance au vieillissement d'un module photovoltaïque 5 à base de Pérovskite. Un tel dispositif 10 correspond par exemple au dispositif de la figure 2. Le dispositif 10 comprend une lampe à diode électroluminescente 1 dont le spectre d'émission correspond au moins en partie au spectre d'absorption du module photovoltaïque 5 (d'autres types de lampe peuvent être utilisés). Le dispositif 10 comprend également au moins un filtre neutre 3 disposé entre la lampe à LEDs 1 et le module photovoltaïque 5 à éclairer. Sur l'exemple de la figure 2, un seul filtre neutre 3 est utilisé mais il est également possible d'utiliser plusieurs filtres disposés les uns derrière les autres entre la lampe à LEDs 1 et le module photovoltaïque 5 afin d'obtenir l'éclairage voulu du module photovoltaïque 5. Le dispositif 10 comprend également des moyens 7 de détermination d'une résistance parallèle du module photovoltaïque 5 et une unité de traitement 9.

Les moyens 7 de détermination d'une résistance parallèle comprennent par exemple des moyens d'application d'une tension variable au module photovoltaïque 5 et des moyens de mesure du courant dans le module photovoltaïque 5. Les moyens de détermination 7 étant par exemple configurés pour faire varier la tension de 0V à la tension de court-circuit du module photovoltaïque 5. Le courant étant mesuré à chaque incrément de tension. Les incréments sont par exemple de 0,02V.

L'unité de traitement 9 est notamment configurée pour appliquer, via la lampe à diode électroluminescente 1, un éclairage du module photovoltaïque 5 dont l'irradiance est inférieure au premier seuil prédéterminé, par exemple entre 1 et 3 W/m².

L'unité de traitement 9 est également configurée pour déterminer, via les moyens 7 de détermination de la résistance parallèle, une valeur de la résistance parallèle du module photovoltaïque 5 éclairé et pour déduire une résistance au vieillissement du module photovoltaïque 5 en fonction de la valeur de résistance parallèle déterminée.

L'unité de traitement 9 comprend par exemple un microprocesseur et des moyens d'enregistrement tels que des mémoires de type ROM et/ou RAM.

L'unité de traitement 9 peut notamment comprendre une base de données comprenant des valeurs de résistance parallèle de différents échantillons mesurés précédemment et peut être configurée pour comparer les valeurs de résistances parallèles mesurées avec les valeurs de résistances parallèles enregistrées pour classer la valeur de résistance parallèle de l'échantillon mesuré par rapport aux valeurs de résistances parallèles des échantillons enregistrés.

Alternativement, la base de données peut comprendre des caractéristiques courant-tension et la caractéristique courant-tension mesurée peut être comparée aux caractéristiques courant-tension enregistrées dans la base de données.

L'unité de traitement 9 peut également être configurée pour appliquer, via la lampe à diode électroluminescente 1, un éclairage du module photovoltaïque 5 dont l'irradiance est égale à un deuxième seuil prédéterminé, par exemple 1000W/m² et pour déterminer, via les moyens de détermination de la résistance parallèle 7, la résistance parallèle du module photovoltaïque 5 éclairé. Une efficacité du module photovoltaïque 5 éclairé est alors estimée à partir de la résistance parallèle déterminée et d'autres paramètres tels que la résistance série...

Le dispositif 10 d'estimation de la résistance au vieillissement d'un module photovoltaïque à base de Pérovskite peut être configuré pour recevoir et éclairer plusieurs modules photovoltaïques 5 et pour déterminer simultanément ou successivement les résistances parallèles des différents modules photovoltaïques 5 et pour déduire une résistance au vieillissement ou une efficacité (selon la valeur de l'irradiance de l'éclairage appliqué) des différents modules photovoltaïques 5 à partir des résistances parallèles mesurées.

Une fois la résistance au vieillissement et éventuellement l'efficacité estimées, il est possible de sélectionner les échantillons ayant une efficacité et une résistance au vieillissement suffisante afin de les soumettre au test standard de résistance au vieillissement.

Dans le cas présent, les deux échantillons testés ont une efficacité similaire (courbes très proches sur la figure 5) mais le premier échantillon associé à la courbe C1 sur la figure 3 présente une résistance plus faible au vieillissement et pourra être écarté. La figure 6 représente le résultat d'un test standard de résistance au vieillissement réalisé sur les deux échantillons utilisés précédemment pour les figures 3 et 5. Le test consiste à mesurer la puissance lorsque le module photovoltaïque 5 est éclairé sous une irradiance prédéterminée, par exemple 1000W/m². L'évolution de cette puissance est alors observée sur une durée prédéterminée, par exemple 110 heures dans le cas de la figure 6. On observe que la puissance du premier échantillon associé à la courbe P1 diminue rapidement tandis que la puissance du deuxième échantillon associé à la courbe P2 diminue beaucoup plus lentement de sorte que le premier échantillon présente une résistance au vieillissement plus faible ce qui confirme le résultat de la figure 3.

Ainsi, en appliquant le procédé d'estimation de la résistance au vieillissement d'un module photovoltaïque 5 décrit en relation avec les figures 1 et 3, il est possible d'estimer la résistance au vieillissement d'un module photovoltaïque 5 de manière rapide, par exemple quelques minutes, de sorte que seuls les modules photovoltaïques 5 dont la résistance au vieillissement est suffisante peuvent être sélectionnés pour passer le test standard de résistance au vieillissement. Un procédé de caractérisation comme décrit en relation avec la figure 4 peut également être appliqué pour prendre également en compte l'efficacité dans la sélection des modules photovoltaïques 5. Les procédés décrits permettent ainsi de limiter le nombre de modules photovoltaïques 5 soumis au test standard et de maximiser les chances des modules photovoltaïques 5 soumis au test d'être conformes au test standard. Or, du fait de la durée importante du test standard, cela permet de réduire les coûts liés à ce test.

## Revendications

1. Procédé d'estimation de la résistance au vieillissement d'un module photovoltaïque (5) à base de Pérovskite dans lequel on éclaire (101, 201) le module photovoltaïque (5) avec une lumière dont le spectre d'émission comprend au moins une partie du spectre d'absorption du module photovoltaïque (5) utilisé et dont l'irradiance est inférieure à un premier seuil prédéterminé, notamment inférieure à une fraction de l'irradiance utilisée pour caractériser l'efficacité d'un module photovoltaïque (5) et dans lequel on détermine (1022, 2022) la valeur de la résistance parallèle du module photovoltaïque (5) éclairé, la résistance au vieillissement étant déduite de la valeur de résistance parallèle mesurée, plus la valeur de résistance parallèle est faible et plus le module photovoltaïque (5) est résistant au vieillissement.

2. Procédé selon la revendication 1 dans lequel le seuil prédéterminé est le plus petit possible, notamment inférieur à 100W/m², notamment inférieur à 10W/m², notamment entre 1W/m² et 3W/m².

3. Procédé selon l'une des revendications précédentes dans lequel la lumière est obtenue par une lampe à diode électroluminescente (1) et au moins un filtre neutre (3).

4. Procédé selon l'une des revendications précédentes dans lequel la valeur de la résistance parallèle est déterminée à partir d'une caractéristique courant-tension du module photovoltaïque (5).

5. Procédé de caractérisation d'un module photovoltaïque à base de Pérovskite comprenant un procédé d'estimation de la résistance au vieillissement selon l'une des revendications 1 à 4 et une étape de caractérisation de l'efficacité du module photovoltaïque (5) dans laquelle on éclaire (204) le module photovoltaïque (5) avec une lumière dont le spectre comprend au moins une partie du spectre d'absorption du module photovoltaïque (5) et dont l'irradiance est égale à un deuxième seuil prédéterminé, supérieure au premier seuil prédéterminé.

6. Procédé selon la revendication précédente dans lequel le deuxième seuil prédéterminé est égal à 1000W/m².

7. Dispositif (10) d'estimation de la résistance au vieillissement d'un module photovoltaïque (5) à base de Pérovskite comprenant une lampe à diode électroluminescente (1) dont le spectre d'émission correspond au moins en partie au spectre d'absorption du module photovoltaïque (5), au moins un filtre neutre (3), des moyens (7) de détermination d'une résistance parallèle du module photovoltaïque (5) et une unité de traitement (9) configurée pour :
- appliquer, via la lampe à diode électroluminescente (1), un éclairage du module photovoltaïque (5) dont l'irradiance est inférieure à un premier seuil prédéterminé, notamment inférieure à une fraction de l'irradiance utilisée pour caractériser l'efficacité d'un module photovoltaïque (5),
- déterminer, via les moyens (7) de détermination de la résistance parallèle, une valeur de la résistance parallèle du module photovoltaïque (5) éclairé et,
- déduire une résistance au vieillissement du module photovoltaïque (5) en fonction de la valeur de résistance parallèle déterminée.

8. Dispositif (10) selon la revendication précédente dans lequel la résistance parallèle est déterminée à partir d'une caractéristique courant-tension et les moyens (7) de détermination de la résistance parallèle comprennent des moyens d'application d'une tension variable au module photovoltaïque (5) et des moyens de mesure du courant dans le module photovoltaïque (5).

9. Dispositif (10) selon la revendication précédente comprenant une base de données comprenant un ensemble de caractéristiques courant-tension et/ou de valeurs de résistances parallèles et dans lequel l'unité de traitement (9) est configurée pour comparer la caractéristique courant-tension et/ou la résistance parallèle déterminée avec les caractéristiques courant-tension et/ou les résistances parallèles de la base de données pour déduire une résistance au vieillissement du module photovoltaïque (5) éclairé.

10. Dispositif (10) selon l'une des revendications 7 à 9 dans lequel l'unité de traitement (9) est également configurée pour :
- appliquer, via la lampe à diode électroluminescente (1), un éclairage du module photovoltaïque (5) dont l'irradiance est égale à un deuxième seuil prédéterminé,
- déterminer, via les moyens (7) de détermination de la résistance parallèle, la résistance parallèle du module photovoltaïque (5) éclairé et,
- estimer une efficacité du module photovoltaïque (5) éclairé en fonction notamment de la résistance parallèle déterminée.

11. Dispositif (10) selon l'une des revendications 7 à 10 configuré pour :
- recevoir et éclairer plusieurs modules photovoltaïques (5) simultanément,
- mesurer les résistances parallèles des différents modules photovoltaïques (5) de manière simultanée ou successivement et,
- déduire une résistance au vieillissement des différents modules photovoltaïques (5) à partir des résistances parallèles mesurées de manière simultanée ou successivement.
